# EUROPEAN PATENT SPECIFICATION

(11) **EP 1 131 378 B1**
(45) Date of publication and mention of the grant of the patent: **23.02.2005**
(21) Application number: 99938883.8
(22) Date of filing: 30.07.1999
(51) Int. Cl.: C08K 5/5399, C08L 71/12, C08L 51/04, C08L 69/00

(54) **FLAME RETARDANT RESIN COMPOSITIONS CONTAINING PHOSPHORAMIDES, AND METHOD FOR MAKING**
FLAMMHEMMENDE HARZZUSAMMENSETZUNGEN, ENTHALTEND PHOSPHORAMIDE, UND HERSTELLUNGSMETHODE
COMPOSITIONS RESINEUSES IGNIFUGEANTES CONTENANT DES PHOSPHORAMIDES, ET LEUR PROCEDE DE FABRICATION

(30) Priority: 31.08.1998 US 144687; 22.01.1999 US 235677; 08.07.1999 US 404458 P
(43) Date of publication of application: 12.09.2001
(73) Proprietor: GENERAL ELECTRIC COMPANY, Schenectady, NY 12345 (US)
(72) Inventor: FALCONE, Neal, Steven, Uncasville, CT 06382 (US); CAMPBELL, John, Robert, Clifton Park, NY 12065 (US)
(74) Representative: Szary, Anne Catherine, Dr.
(86) International application number: PCT/US1999/017226
(87) International publication number: WO 2000/012612

(56) References cited:
- EP-A- 0 171 730
- WO-A-93/22373
- DE-A- 2 505 326
- GB-A- 1 517 652
- US-A- 3 937 765
- PATENT ABSTRACTS OF JAPAN vol. 1998, no. 11, 30 September 1998 (1998-09-30) & JP 10 175985 A (TOSOH CORP), 30 June 1998 (1998-06-30)
- PATENT ABSTRACTS OF JAPAN vol. 005, no. 008 (C-039), 20 January 1981 (1981-01-20) & JP 55 135158 A (ASAHI CHEM IND CO LTD), 21 October 1980 (1980-10-21)
- TALLEY, JOHN J.: "Preparation of sterically hindered phosphoramidates" JOURNAL OF CHEMICAL AND ENGINEERING DATA., vol. 33, no. 2, 1988, pages 221-222, XP000852880 AMERICAN CHEMICAL SOCIETY., US ISSN: 0021-9568 cited in the application

## Description

### BACKGROUND OF THE INVENTION

The present invention relates to resin compositions comprising a phosphoramide compound having a glass transition temperature of at least 0°C, preferably of at least 10°C, and most preferably of at least 20°C. The invention also relates to methods to make the resin compositions and articles made from the resin compositions.

Compounds containing phosphorus have been used in resin compositions for a variety of reasons. For example, various phosphites have been utilized to enhance the melt stability and/or color stability of resin compositions. Alternatively, various organic phosphate esters have been utilized in resin compositions to improve the flame resistance properties of the compositions and/or to enhance the melt flow characteristics of the compositions. Certain water soluble phosphoramides have also been used in the textile industry as flame retardant finishes for fabrics.

As part consolidation and weight reduction continues to evolve in many industries, the physical property demands placed upon resin manufacturers are increasing. Key industries increasing the demands include the electronics and computer industries, especially for computer housings, computer monitor housings, and printer housings. One increasing demand is for materials that possess higher heat resistance while preferably substantially retaining other key physical properties. Another increasing demand is for materials that are rated in the Underwriter's Laboratory UL-94 test protocol as V-0, V-1, or V-2. It is therefore apparent that new resin compositions that meet these and other demands continue to be sought.

### SUMMARY OF THE INVENTION

The present invention provides resin compositions comprising the following and any reaction products thereof
a) a thermoplastic resin and
b) at least one phosphoramide having a glass transition point of at least 0°C, preferably of at least about 10°C, and most preferably of at least 20°C, of the formula: 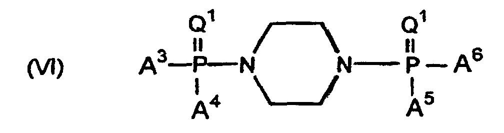 wherein each Q' is independently oxygen or sulfur and each A moiety is a 2,6-dimethylphenoxy moiety or a 2,4,6-trimethylphenoxy moiety.

The present invention also provides articles made from the resin compositions. Furthermore, the present invention provides methods to make resin compositions having improved heat and/or processability over compositions known in the art.

In one embodiment the thermoplastic resin is selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin.

In a second embodiment the thermoplastic resin is selected from the group consisting of high impact polystyrene resin, syndiotactic polystyrene, polyphenylene ether / high impact polystyrene resin blends, polyphenylene ether / syndiotactic polystyrene resin blends, polycarbonate SAN blends, polycarbonate-ABS blends, polycarbonate-SAN-ABS blends, and polycarbonate-polyester blends.

In a third embodiment the thermoplastic resin is at least one of polyesters, polycarbonates, polyphenylene ethers, high impact polystyrenes, syndiotactic polystyrenes, acrylonitrile-butadiene-styrene copolymers, and styrene-acrylonitrile copolymers.

Polyesters useful in the compositions of the invention include those comprising structural units of formula II: 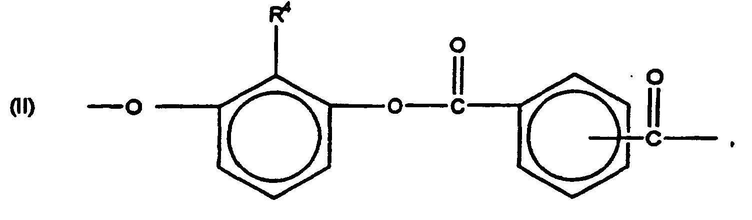 wherein R⁴ is hydrogen or C₁₋₄ alkyl, optionally in combination with structural units of the formula III : 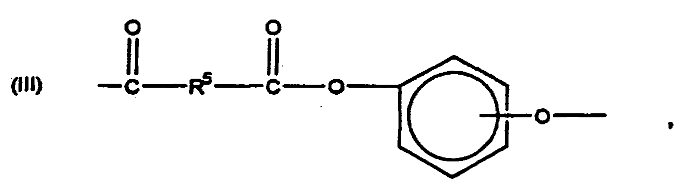 wherein R⁵ is a divalent C₄₋₁₂ aliphatic, alicyclic or mixed aliphatic-alicyclic radical. The latter polyesters are prepared by the reaction of a 1,3-dihydroxybenzene with at least one aromatic dicarboxylic acid chloride under alkaline conditions. Structural units of formula II contain a 1,3-dihydroxybenzene moiety which may be substituted with halogen, usually chlorine or bromine, or preferably with C₁₋₄ alkyl; e.g., methyl, ethyl, isopropyl, propyl, butyl. Said alkyl groups are preferably primary or secondary groups, with methyl being more preferred, and are most often located in the ortho position to both oxygen atoms although other positions are also contemplated. The most preferred moieties are resorcinol moieties, in which R⁴ is hydrogen. Said 1,3-dihydroxybenzene moieties are linked to aromatic dicarboxylic acid moieties which may be monocyclic moieties, e.g., isophthalate or terephthalate, or polycyclic moieties, e.g., naphthalenedicarboxylate. Preferably, the aromatic dicarboxylic acid moieties are isophthalate and/or terephthalate: either or both of said moieties may be present. For the most part, both are present in a molar ratio of isophthalate to terephthalate in the range of 0.25-4.0:1, preferably 0.8-2.5:1.

In the optional soft block units of formula II, resorcinol or alkylresorcinol moieties are again present in ester-forming combination with R⁵ which is a divalent C₄₋₁₂ aliphatic, alicyclic or mixed aliphatic-alicyclic radical. It is preferably aliphatic and especially C₈₋₁₂ straight chain aliphatic. A particularly preferred arylate polymer containing soft block units is one consisting of resorcinol isophthalate and resorcinol sebacate units in a molar ratio between 8.5:1.5 and 9.5:0.5.

Polycarbonates useful in the compositions of the invention include those comprising structural units of the formula IV: 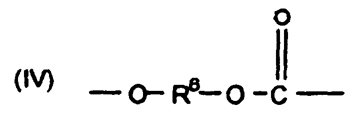 wherein at least about 60 percent of the total number of R⁶ groups are aromatic organic radicals and the balance thereof are aliphatic, alicyclic, or aromatic radicals. More preferably, R⁶ is an aromatic organic radical and still more preferably a radical of the formula V:

(V) ―A¹―Y¹―A²―,

wherein each A¹ and A² is a monocyclic divalent aryl radical and Y¹ is a bridging radical in which one or two atoms, separate A¹ from A². The preferred embodiment is one in which one atom separates A¹ from A². Illustrative non-limiting examples of radicals of this type are -O-, -S-, -S(O)- or -S(O₂)-, -C(O)-, methylene, cyclohexyl-methylene, 2-[2.2.1]-bicycloheptylidene, ethylidene, isopropylidene, neopentylidene, cyclohexylidene, 3,3,5-trimethylcyclohexylidene, cyclopentadecylidene, cyclododecylidene, and adamantylidene. The bridging radical Y¹ is most often a hydrocarbon group and particularly a saturated group such as methylene, cyclohexylidene, 3,3,5-trimethylcyclohexylidene, or isopropylidene.

Preferred polycarbonates are derived from dihydric phenols in which only one atom separates A¹ and A². Some illustrative, non-limiting examples of dihydric phenols include the dihydroxy-substituted aromatic hydrocarbons disclosed by name or formula (generic or specific) in U.S. Patent 4,217,438, which is incorporated herein by reference. Some preferred examples of dihydric phenols include 4,4'-dihydroxybiphenyl; 4,4'-(3,3,5-trimethylcyclohexylidene)diphenol; 2,2-bis(4-hydroxyphenyl)propane (commonly known as bisphenol A); 2,2-bis(4-hydroxy-3,5-dimethylphenyl)propane; 2,4'-dihyroxydiphenylmethane; bis(2-hydroxyphenyl)methane; bis(4-hydroxyphenyl)methane; bis(4-hydroxy-5-nitrophenyl)methane; bis(4-hydroxy-2,6-dimethyl-3-methoxyphenyl)methane; 1,1-bis(4-hydroxyphenyl)ethane; 1,1-bis(4-hydroxy-2-chlorophenyl)ethane; 2,2-bis(3-phenyl-4-hydroxyphenyl)-propane; bis(4-hydroxyphenyl)-cyclohexylmethane; 2,2-bis(4-hydroxyphenyl)-1-phenylpropane; resorcinol; C₁₋₃ alkyl-substituted resorcinols, and 6,6'-dihydroxy- 3,3,3',3-tetramethyl-1,1'-spirobiindane.

The most preferred polycarbonates are bisphenol A polycarbonates, in which each of A¹ and A² is p-phenylene and Y¹ is isopropylidene. Preferably, the weight average molecular weight of the initial polycarbonate ranges from 5,000 to 100,000; more preferably from 10,000 to 65,000, still more preferably from 16,000 to 40,000, and most preferably from 20,000 to 36,000. Suitable polycarbonates may be made using any process known in the art, including interfacial, solution, solid state, or melt processes.

In one embodiment the present invention comprises a composition containing at least one polycarbonate. In another embodiment the invention comprises compositions containing two different polycarbonates. Both homopolycarbonates derived from a single dihydroxy compound monomer and copolycarbonates derived from more than one dihydroxy compound monomer are encompassed. In a preferred embodiment compositions comprise a bisphenol A homopolycarbonate and a copolycarbonate comprising bisphenol A monomer units and 4,4'-(3,3,5-. trimethylcyclohexylidene)diphenol monomer units. Preferably, the copolycarbonate comprises 5-65 mole %, more preferably 15-60 mole %, and most preferably 30-55 mole % of 4,4'(3,3,5-trimethylcyclohexylidene)diphenol with the remaining dihydroxy monomer being bisphenol A. The weight ratio of bisphenol A polycarbonate to the aforementioned copolycarbonate in compositions of the present invention is preferably between 95:5 and 70:30 and more preferably between 85:15 and 75:25.

Also suitable for use in the present invention are polyestercarbonates. The polyestercarbonates may generally be termed copolyesters containing carbonate groups, carboxylate groups, and aromatic carbocyclic groups in the polymer chain, in which at least some of the carboxylate groups and at least some of the carbonate groups are bonded directly to ring carbon atoms of the aromatic carbocyclic groups. These polyestercarbonates are, in general, prepared by reacting at least dihydric phenol, at least one difunctional carboxylic acid or reactive derivative of the acid such as the acid dihalide, and a carbonate precursor. Suitable dihydric phenols include, but are not limited to, those named or referred to hereinabove. Some illustrative, non-limiting examples of suitable aromatic dicarboxylic acids include phthalic acid, isophthalic acid, terephthalic acid, homophthalic acid, o-, m-, and p-phenylenediacetic acid; and the polynuclear aromatic acids such as diphenic acid, 1,4-naphthalene dicarboxylic acid, 2,6-naphthalene dicarboxylic acid, and the like. These acids may be used either individually, or as a mixture of two or more different acids in the preparation of suitable polyestercarbonates.

The polyestercarbonates which find use in the instant invention and the methods for their preparation are well known in the art as disclosed in, for example, U.S. Pat. Nos. 3,030,331; 3,169,121; 3,207,814; 4,194,038; 4,156,069; 4,238,596; 4,238,597; 4,487,896; 4,506,065, and in copending application Ser. No. 09/181,902, filed Oct. 29, 1998, and assigned to the same assignee as the instant application, Among the properties characterizing these polymers is a relatively high distortion temperature under load (DTUL) as well as a relatively high impact strength as measured by a notched Izod test protocol.

The polyarylene ethers are most often polyphenylene ethers having structural units of the formula: 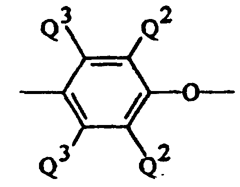 wherein each Q² is independently halogen, primary or secondary lower alkyl, phenyl, haloalkyl, aminoalkyl, hydrocarbonoxy, or halohydrocarbonoxy wherein at least two carbon atoms separate the halogen and oxygen atoms, and each Q³ is independently hydrogen, halogen, primary or secondary lower alkyl, phenyl, haloalkyl, hydrocarbonoxy or halohydrocarbonoxy as defined for Q².

Both homopolymer and copolymer polyphenylene ethers are included. The preferred homopolymers are those containing 2,6-dimethyl-1,4-phenylene ether units. Suitable copolymers include random copolymers containing such units in combination with, for example, 2.3.6-trimethyl-1,4-phenylene ether units. Also included are polyphenylene ethers containing moieties prepared by grafting onto the polyphenylene ether in known manner such materials as vinyl monomers or polymers such as polystyrenes and elastomers, as well as coupled polyphenylene ethers in which coupling agents such as low molecular weight polycarbonates, quinones, heterocycles and formals undergo reaction in known manner with the hydroxy groups of two polyphenylene ether chains to produce a higher molecular weight polymer.

The polyphenylene ethers generally have an intrinsic viscosity greater than 0.1, most often in the range of 0.2-0.6 and especially 0.35-0.6 deciliters per gram (dl./g.), as measured in chloroform at 25°C.

The polyphenylene ethers are typically prepared by the oxidative coupling of at least one monohydroxyaromatic compound such as 2.6-xylenol or 2,3,6-trimethylphenol. Catalyst systems are generally employed for such coupling; they typically contain at least one heavy metal compound such as a copper, manganese or cobalt compound, usually in combination with various other materials.

Particularly useful polyphenylene ethers for many purposes are those which comprise molecules having at least one aminoalkyl-containing end group. The aminoalkyl radical is covalently bound to a carbon atom located in an ortho position to a hydroxy group. Products containing such end groups may be obtained by incorporating an appropriate primary or secondary monoamine such as di-n-butylamine or dimethylamine as one of the constituents of the oxidative coupling reaction mixture. Also frequently present are 4-hydroxybiphenyl end groups and/or biphenyl structural units, typically obtained from reaction mixtures in which a by-product diphenoquinone is present, especially in a copper-halide-secondary or tertiary amine system. A substantial proportion of the polymer molecules, typically constituting as much as about 90% by weight of the polymer, may contain at least one of said aminoalkyl-containing and 4-hydroxy-biphenyl end groups. It will be apparent to those skilled in the art from the foregoing that the polyphenylene ethers contemplated for use in the invention include all those presently known, irrespective of variations in structural units or ancillary chemical features:

Both homopolymer and copolymer thermoplastic polymers are included in the compositions of the present invention. Copolymers may include random, block or graft type. Thus, for example, suitable polystyrenes include homopolymers, such as amorphous polystyrene and syndiotactic polystyrene, and copolymers. The latter embraces high impact polystyrene (HIPS), a genus of rubber-modified polystyrenes comprising blends and grafts wherein the rubber is a polybutadiene or a rubbery copolymer of 70-98% styrene and 2-30% diene monomer. Also included are ABS copolymers, which are typically grafts of styrene and acrylonitrile on a previously formed diene polymer backbone (e.g., polybutadiene or polyisoprene). Suitable ABS copolymers may be produced by any methods known in the art. Especially preferred ABS copolymers are typically produced by mass polymerization (often referred to as bulk ABS) or emulsion polymerization (often referred to as high rubber graft ABS).

The preferred thermoplastic polymers for many purposes are polyesters, polycarbonates, polyphenylene ethers, polystyrene resin, high impact polystyrene resin (HIPS), and styrene-acrylonitrile copolymers (SAN), including ABS copolymers. These may be employed individually or as blends. Especially preferred blends include those of polyphenylene ether with at least one of HIPS, amorphous polystyrene, and syndiotactic polystyrene; and polycarbonate blends with at least one of ABS, SAN, and polyester.

In resinous compositions there is often an improvement in melt flow and/or other physical properties when one molecular weight grade of at least one resinous constituent is combined with a relatively lower molecular weight grade of similar resinous constituent. Illustrative, non-limiting examples include compositions containing polycarbonate, polyphenylene ether, thermoplastic polyester, thermoplastic elastomeric polyester, or polyamide. For example, in a polycarbonate-containing blend there is often an improvement in melt flow when one molecular weight grade of polycarbonate is combined with a proportion of a relatively lower molecular weight grade of similar polycarbonate. Therefore, the present invention encompasses compositions comprising only one molecular weight grade of a particular resinous constituent and also compositions comprising two or more molecular weight grades of similar resinous constituent. When two or more molecular weight grades of similar resinous constituent are present, then the weight average molecular weight of the lowest molecular weight constituent is 10% to 95%, preferably 40% to 85%, and more preferably 60% to 80% of the weight average molecular weight of the highest molecular weight constituent. In one representative, non-limiting embodiment polycarbonate-containing blends include those comprising a polycarbonate with weight average molecular weight between 28,000 and 32,000 combined with a polycarbonate with weight average molecular weight between 16,000 and 26,000. When two or more molecular weight grades of similar resinous constituent are present; the weight ratios of the various molecular weight grades may range from 1 to 99 parts of one molecular weight grade and from 99 to 1 parts of any other molecular weight grades. A mixture of two molecular weight grades of a resinous constituent is often preferred, in which case the weight ratios of the two grades may range from 99:1 to 1:99, preferably from 80:20 to 20:80, and more preferably from 70:30 to 50:50. Since not all manufacturing processes for making a particular resinous constituent are capable of making all molecular weight grades of that constituent, the present invention encompasses compositions comprising two or more molecular weight grades of similar resinous constituent in which each of the similar resins is made by a different manufacturing process. In one particular embodiment the instant invention encompasses compositions comprising a polycarbonate made by an interfacial process in combination with a polycarbonate of different weight average molecular weight made by a melt process.

Depending upon the manner in which they are prepared, isolated, and purified, the phosphoramides used in the present invention may contain various impurities, such as acidic, basic, and halide impurities, or their precursors. Representative acidic impurities include, but are not limited to, phosphoric acids and tertiary amine hydrohalides. Representative precursors to acidic impurities include, but are not limited to, phosphoryl chlorides and pyrophosphates, which may be readily hydrolyzed to phosphoric acids. Representative basic impurities include, but are not limited to, secondary and tertiary amines. Representative precursors to basic impurities include, but are not limited to, tertiary amine hydrohalides. Representative halide impurities include, but are not limited to, chloride or bromide derived from tertiary amine hydrohalides or phosphoryl halides, or catalyst residues.

A particular impurity is the pyrophosphate derived from reaction of two moles of disubstituted phosphoryl halide with water in the phosphoramide reaction mixture, or in isolation or purification of the phosphoramide product. For example, two moles of dixylylphosphoryl chloride may react with water to produce tetraxylyl pyrophosphate (hereinafter referred to as X-PYRO) and two moles of hydrochloric acid. Pyrophosphates may react further with water in the phosphoramide reaction mixture, or in isolation or purification of the phosphoramide product, or subsequently in the resinous compositions embodied in the present invention, to produce two moles of the corresponding phosphoric acid.

The presence of any acidic, basic, or halide impurities, or their precursors in resinous blends may have a detrimental effect on certain blend properties. For example, molded parts of said blends may show deterioration in mechanical properties (such as loss of impact strength), optical properties (such as increasing haze), thermal properties, hydrolytic stability, and the like. Although various mechanisms may be responsible for any deterioration in blend properties, one mechanism is the degradation in the molecular weight of at least one resinous component in the blend. Common examples include the degradation in the molecular weight of condensation polymers, including, but not limited to, polyesters, polyamides, and polycarbonates, in the presence of acidic, basic, or halide impurities. In particular, polycarbonate molecular weight may be sensitive to all these types of impurities, and the properties of polycarbonate-containing compositions may be adversely affected. Illustrative, non-limiting polycarbonate compositions include polycarbonate-SAN blends; polycarbonate-ABS blends; polycarbonate-polyester blends; and compositions containing essentially polycarbonate as the resinous component.

In one embodiment the present invention includes resinous compositions containing at least one phosphoramide, said phosphoramide being substantially free of acidic, basic, or halide impurities, or their precursors. Substantially free in this context means that the molecular weight of a resinous component in the compositions does not show significant deterioration with time under conditions of high temperature and humidity compared to a composition not containing said phosphoramide. Typical conditions of temperature are greater than 70°C and humidity greater than 70% relative humidity.

Acidic, basic, or halide impurities, and their precursors may be removed from phosphoramide products of the present invention by means commonly know in the art, including, but not limited to, distillation, recrystallization, solvent extraction, devolatilization, and like methods. It has been found that the substantial elimination of water in reactions to form phosphoramides of the present invention also leads to a decrease in certain impurities, including pyrophosphates.

The compositions of the invention may contain essentially a single phosphoramide or a mixture of two or more different types of phosphoramides. Compositions containing essentially a single phosphoramide are preferred.

When a phosphoramide having a glass transition point of at least 0°C is used as a source of phosphorus in resin compositions, it was unexpectedly found that a higher heat deflection temperature of test specimens made from the resin composition could be obtained as compared to compositions containing an organophosphate known in the art for enhancing the processability and/or flame resistance characteristics of the composition.

The phosphoramide used in the compositions according to the invention comprises phosphoramide having a glass transition temperature of at least 0°C, preferably of at least 10°C, and most preferably of at least 20°C, of the formula VI: 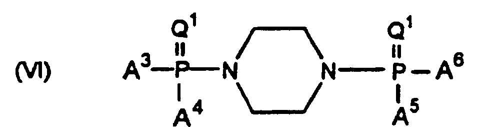 wherein each Q¹ is independently oxygen or sulfur, and each of A³⁻⁶ is a 2,6-dimethylphenoxy or 2,4,6-trimethylphenoxy moiety said phosphoramide preferably being substantially free of acidic, basic, or halide impurities, or their precursors. In an especially preferred embodiment of the invention, each Q¹ is oxygen, and each A³⁻⁶ moiety is a 2.6-dimethylphenoxy moiety or a 2,4,6-trimethylphenoxy moiety. These phosphoramides are piperazine-type phosphoramides. In the above formula wherein each Q¹ is oxygen, and each A³⁻⁶ moiety is a 2,6-dimethylphenoxy moiety, the glass transition temperature of the phosphoramide is about 62°C and the melting point is about 192°C. Conversely, in the above formula wherein each Q¹ is oxygen, and each A³⁻⁶ moiety is phenoxy, the glass transition temperature of the phosphoramide is about 0°C and the melting point is about 188°C. It was unexpected that the glass transition temperature would be so high (i.e. about 62°C) for the phosphoramide of formula VI where each Q¹ is oxygen, and wherein each of A³⁻⁶ is a 2,6-dimethylphenoxy moiety as compared to the corresponding phosphoramide of formula VI wherein each Q¹ is oxygen, and each of A³⁻⁶ is a phenoxy moiety (i.e. about 0°C), especially since the melting points for the phosphoramides differ by only about 4°C. For comparison, the glass transition temperature of tetraphenyl resorcinol diphosphate is about -38°C. It is also possible to make phosphoramides with intermediate glass transition temperatures by using a mixture of various substituted and non-substituted aryl moieties within the phosphoramide.

The resinous compositions of this invention typically contain a flame retarding and/or processability enhancing amount of at least one phosphoramide, or a mixture of (c) at least one phosphoramide and (d) at least one non-polymeric or polymeric phosphorus additive selected from the group consisting of organic phosphate esters, thiophosphate esters, phosphonate esters, thiophosphonate esters, phosphinate esters, thiophosphinate esters, phosphine oxides, and thiophosphine oxides. For convenience, compounds selected from group (d) are hereinafter referred to as "phosphorus additives". Preferred phosphorus additives are non-polymeric organic phosphate esters including, for example, alkyl phosphate esters, aryl phosphate esters, resorcinol-based phosphate esters, and bisphenol-based phosphate esters known in the art.

The amount of at least one phosphoramide or mixture of at least one phosphoramide and at least one phosphorus additive is typically in the range of 0.1-5 parts, preferably 0.25-2.5 parts, of phosphorus per 100 parts of resinous materials (phr), all percentages herein being by weight. The total amount of phosphoramide or of phosphoramide/phosphorus additive mixture is most often in the range of 1-50 phr, preferably 5-35 phr.

Flame retardancy is preferably measured according to the Underwriters' Laboratory UL-94 protocol. A flame retarding amount is an amount effective to render the composition at least a V-2 rating, preferably at least a V-1 rating, and most preferably a V-0 rating after testing in the UL-94 protocol when measured on a test specimen of 0.76 to 3.18 mm (0.03 to 0.125 inch) in thickness by 12.7 mm (0.5 inch) by 12.7 cm (5 inch), preferably 3.18 mm (0.125 inch) in thickness by 12.7 mm (0.5 inch) by 12.7 cm (5 inch), more preferably 1.52 mm (0.06 inch) in thickness by 12.7 mm (0.5 inch) by 12.7 cm (5 inch) and most preferably 0.76 mm (0.03 inch) in thickness by 12.7 mm (0.5 inch) by 12.7 cm (5 inch) dimensions. Enhanced processability can be determined, for example, as a reduction in extruder torque during compounding, reduced pressure in injection molding, reduced viscosity, and/or decreased cycle time.

In one embodiment of the present invention halogen-containing flame retardants or other halogen-containing species may also be present in the compositions. In many resinous compositions, the combination of a halogen-containing flame retardant and at least one phosphoramide (or mixture of phosphoramide with at least one phosphorus additive), particularly including a phosphoramide having a glass transition point of at least 0°C, provides both suitable flame retardant properties and unexpectedly improved high temperature properties (such as measured, for example, by HDT or Tg of a resinous phase). Illustrative, non-limiting examples of halogen-containing flame retardants or halogen-containing species include brominated flame retardants and phosphoramides containing halogenated aromatic substituents. Due to environmental regulations chlorine-free and bromine-free compositions may be preferred for certain applications. Therefore, in a preferred embodiment the present invention includes compositions comprising a thermoplastic resin and at least one phosphoramide having a glass transition point of at least 0°C, said compositions being essentially free of chlorine and bromine. In this context essentially free means that no chlorine- or bromine-containing species has been added to the resinous compositions in their formulation. In another of its embodiments the present invention includes articles obtained from said chlorine-free or bromine-free compositions.

The compositions of the invention may also contain other conventional additives including stabilizers, inhibitors, plasticizers, fillers, mold release agents, and anti-drip agents. The latter are illustrated by tetrafluoroethylene polymers or copolymers, including mixtures with such other polymers as polystyrene-co-acrylonitrile (sometimes referred to herein as styrene acrylonitrile copolymer).

A principal characteristic of preferred compositions of the invention is their improved high temperature properties. These are demonstrated by the fact that the decrease in glass transition temperature (Tg) exhibited as a result of the incorporation of a phosphoramide in the composition is substantially less than the corresponding decrease exhibited in blends containing, for example, phosphate esters such as bis(diaryl phosphates) of dihydroxyaromatic compounds. This is evident when a phosphoramide is compared to the organic phosphate ester in amounts suitable to provide enhanced flame resistance when measured, for example, in the UL-94 test procedure. In the case of phase-separated blends such as polycarbonate-ABS blends, the decrease in Tg is noted in the polycarbonate phase.

Experience has shown that the flame retarding properties of a phosphoryl-based compound included in a resinous composition are generally proportional to the amount of phosphorus in the composition rather than to the amount of the compound itself. Thus, equal weights of two additives having different molecular weights but the same flame retarding properties may produce different UL-94 results, but amounts of the two additives which contribute the same proportion of phosphorus to the resinous composition will produce the same UL-94 results. On the other hand, other physical properties such as high temperature resistance are dependent on the amount of the compound itself and relatively independent of the phosphorus proportion therein. For this reason, the dependence of flame retarding and high temperature resistance of compositions containing two phosphorus-based compounds may not follow the same pattem.

It has been shown, however, with respect to the preferred phosphoramides employed according to the present invention that their superior properties of flame retardance and high temperature resistance are consistent. Thus, for example, proportions of the prior art additive resorcinol bis(di-2,6-xylyl phosphate) effective to confer a suitable flame-out time on certain resinous compositions are similar to those produced by a typical bis(2,6-xylyl)-phosphoramide at an essentially equivalent level of phosphorus, but the bisphosphoramide has a substantially lower tendency to decrease heat deflection temperature (HDT) despite the slightly greater amount of the bulk additive.

It should be clear that the present invention also affords methods to increase the heat distortion temperature of flame resistant compositions containing an amount of a phosphorus-containing compound effective to render the composition a flame rating of at least V-2, preferably of at least V-1, most preferably V-0, in the UL-94 protocol, wherein the method comprises combining at least one thermoplastic resin and at least one phosphoramide having a glass transition point of at least 0°C, preferably of at least 10°C, and most preferably of at least 20°C, said phosphoramide being substantially free of acidic, basic, or halide impurities, or their precursors. In a preferred embodiment the invention also affords methods to increase the heat distortion temperature of chlorine-free and bromine-free, flame resistant compositions as described in the previous sentence. The method may be used to increase the heat distortion temperature of compositions containing essentially a single phosphoramide, or a mixture of two or more different types of phosphoramide. Compositions containing essential a single phosphoramide are often preferred. Useful thermoplastic resins have been described herein. Especially preferred thermoplastic resins are polycarbonate, most especially bisphenol A-based polycarbonate, and blends of polycarbonate, especially polycarbonate-SAN-ABS blends and polycarbonate-ABS blends, in which the amount of ABS may typically vary from about 1 to 45 wt. %. An especially preferred phosphoramide is N,N'-bis-[di-(2,6-xylyl)-phosphoryl]piperazine. The method may further comprise at least one phosphorus additive selected from the group consisting of organic phosphate esters, thiophosphate esters, phosphonate esters, thiophosphonate esters, phosphinate esters, thiophosphinate esters, phosphine oxides, and thiophosphine oxides. Preferably, the phosphorus additive is a non-polymeric organic phosphate ester. It should also be clear that the present invention includes compositions made by the methods as well as articles made from the compositions.

Preparation methods for the compositions of the invention are typical of those employed for resinous blends. They may include such steps as dry blending followed by melt processing, the latter operation frequently being performed under continuous conditions as by extrusion. Following melt processing, the compositions are molded into test specimens by conventional means such as injection molding.

The addition of at least one phosphoramide or mixture of at least one phosphoramide and at least one phosphorus additive to the compositions of the present invention may be by mixing all of the blend components together prior to melt processing. Alternatively, any or a combination of any of the phosphorus-containing species, particularly a phosphoramide or a phosphorus additive, may be combined with at least one resinous blend component as a concentrate in a prior processing step. Such concentrates are often made by melt processing. The concentrate may then be combined with the remaining blend components.

The various embodiments of the invention are inclusive of simple blends comprising at least one thermoplastic resin and at least one phosphoramide, and also of compositions in which one or more of said materials has undergone chemical reaction, either by itself or in combination with another blend component. When proportions are specified, they apply to the originally incorporated materials rather than those remaining after any such reaction.

In another of its embodiments the present invention comprises articles of manufacture made from the instantly disclosed compositions. Such articles may be transparent, translucent, or opaque depending upon the blend composition. Said articles can be made by any convenient means known in the art. Typical means include, but are not limited to, injection molding, thermoforming, blow molding, and calendering. Especially preferred articles include indirect and direct wound deflection yokes for all cathode ray tube applications including television and computer monitors, slit type deflection yokes, mold coil deflection yokes, television backplates, docking stations, pedestals, bezels, pallets, electronic equipment such as switches, switch housings, plugs, plug housings, electrical connectors, connecting devices, sockets; housings for electronic equipment such as television cabinets, computer housings, including desk-top computers, portable computers, lap-top computers, palm-held computers; monitor housings, printer housings, keyboards, FAX machine housings, copier housings, telephone housings, mobile phone housings, radio sender and/or receiver housings, lights and lighting fixtures, battery chargers, battery housings, antenna housings, transformers, modems, cartridges, network interface devices, circuit breakers, meter housings, panels for wet and dry appliances such as dishwashers, clothes washers, clothes dryers, refrigerators; heating and ventilation enclosures, fans, air conditioner housings, cladding and seating for indoor and outdoor application such as public transportation including trains, subways, buses; automotive electrical components.

The invention is illustrated by the following examples. All parts and percentages are by weight. Intrinsic viscosity was determined in chloroform at 25°C. HDT values were determined at 264 psi (1820 kPa) according to ASTM procedure D648.

### EXAMPLE 1

Blends of various amounts of a bisphenol A homopolycarbonate, 6.5 parts of a commercially available high rubber graft ABS copolymer and 9 parts of a commercially available SAN copolymer were prepared under identical conditions by blending in a Henschel mixer followed by extrusion on a twin screw extruder and were molded into test specimens. The blends also contained conventional additives including 0.4 part of polytetrafluoroethylene dispersed within styrene-acrylonitrile copolymer as an anti-drip agent, which were not considered in determining proportions, and various amounts of the following phosphoryl-based flame retardant additives: N,N'-bis-[di-(2,6-xylyl)phosphoryl]piperazine (XPP), a compound according to formula VI: 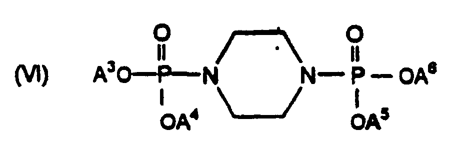 wherein each A moiety is a 2,6-dimethylphenyl residue; N,N'-bis(neopentylenedioxy phosphoryl)piperazine (NPP), a compound of similar structure but wherein each pair of A moieties on each phosphorus atom (e.g. the A³ and A⁴ pair) is a bridging neopentyl residue; N,N'-bis(diphenyl phosphoryl)piperazine (PPP), a compound of similar structure but wherein each A moiety is a phenyl residue; and resorcinol bis(diphenyl phosphate) (RDP) and bisphenol A bis(diphenyl phosphate) (BPADP), two conventional phosphate esters. The FOT (total flameout times for first and second ignitions for 5 bars of 3.18 mm (0.125 inch) thickness) and Tg of the polycarbonate phase of each test specimen was determined and the results are given in Table 1.

**TABLE I**

| Sample | Base | 1 | 2* | 3* | 4* | 5* |
|---|---|---|---|---|---|---|
| Polycarbonate, parts | 81.3 | 72.2 | 76.9 | 73.9 | 73.8 | 71.6 |
| FR, identity | none | XPP | NPP | PPP | RDP | BPADP |
| FR, phr | 0 | 12.4 | 6.9 | 10.4 | 10.7 | 13.2 |
| FR, phr P | 0 | 1.16 | 1.11 | | 0.97 | 1.02 |
| FR, %P | 0 | 1.02 | 1.01 | 1.04 | 1.03 | 1.04 |
| FOT, sec | bums | 19.4 | 84 | -- | 20.3 | 27.3 |
| Tg, °C | 147 | 131 | 149 | 121 | 111 | 112 |

| | | | | | | |
|---|---|---|---|---|---|---|
| * comparative | | | | | | |

It is apparent that the compositions of this invention had an significantly reduced FOT and a Tg that differed from that of polycarbonate (147°C) in a base composition not containing a phosphoramide or phosphate ester by an acceptable increment. Sample 2 had a Tg essentially equal within experimental error to that of the polycarbonate in the base composition but the FOT was appreciably higher than that obtained with XPP. Sample 3 utilizing PPP had a significantly lower Tg that that of XPP and NPP. It was unexpected that XPP-containing compositions (e.g., sample 1) would exhibit such superior FOT as compared to NPP-containing compositions (e.g., sample 2), and such a large increase in polycarbonate Tg as compared to PPP-containing compositions (e.g., sample 3). Samples 4 and 5, employing conventional flame retardants (FR), had unacceptably low Tg's for many commercial applications. The variations in FR content in terms of phr of total FR and of phosphorus are not considered significant from the standpoint of properties.

### EXAMPLE 2

In the same base composition used for Example 1, a composition was made containing 4.5 parts RDP and 5.7 XPP. The resultant composition has a flame out time of 17 seconds and the polycarbonate had a Tg of 127°C. The glass transition temperature is higher for this composition that would be expected based upon the results obtained in samples 1 and 4.

### EXAMPLE 3

Blends of 62 parts of a commercially available poly(2,6-dimethyl-1,4-phenylene ether) and 38 parts of a commercially available HIPS were prepared and molded under identical conditions similar to those of Example 1. The blends also contained conventional additives including 0.21 part of a polytetrafluoroethylene/styrene-acrylonitrile copolymer as an anti-drip agent, which were not considered in determining proportions, and 20.5 phr of XPP, RDP and BPADP as phosphoryl-based flame retardant additives. The FOT (total flameout times for first and second ignitions for 5 bars of 1.52 mm (0.06 inch) thickness) and heat deflection temperature (HDT) of each test specimen was determined and the results are given in Table II.

**TABLE II**

| Sample | 6 | 7* | 8* |
|---|---|---|---|
| FR, identity | XPP | RDP | BPADP |
| FR, phr P | 1.92 | 1.85 | 1.58 |
| FOT, sec | 24 | 21 | 37 |
| HDT,°C | 223.9 | 177.9 | 190.5 |

| | | | |
|---|---|---|---|
| * comparative | | | |

Again, it is apparent that the composition of the invention (Sample 6) had acceptable FR properties and a significantly higher HDT than the compositions containing conventional FR additives, indicating superior high temperature properties.

### EXAMPLE 4

A blend of 40 parts of a commercially available poly(2,6-dimethyl-1,4-phenylene ether) and 60 parts of a commercially available HIPS were prepared and molded under conditions similar to those of Example 3, using N,N'-bis[di-(2,6-xylyl)phosphoryl]piperazine (XPP) as the flame retardant material in essentially the same proportion. The observed FOT was 34 seconds.

### EXAMPLE 5

A commercially available HIPS, optionally containing poly(2,6-dimethyl-1,4-phenylene ether) and / or a polystyrene-polybutadiene-polystyrene elastomer, were prepared and molded under conditions similar to those of Example 1, using N,N'-bis[di-(2,6-xylyl)phosphoryl]piperazine (XPP) as the flame retardant material. The compositions and flame out times (FOT, as defined above for Table 1) are provided in Table III.

**TABLE III**

| Sample | Base | 9 | 10 | 11 | 12 | 13 |
|---|---|---|---|---|---|---|
| HIPS, parts | 100 | 90 | 70 | 65 | 72 | 78.5 |
| PPE, parts | 0 | 0 | 0 | 25 | 7 | 3.5 |
| Rubber, parts | 0 | 0 | 0 | 0 | 2 | 3.5 |
| XPP, parts | 0 | 10 | 30 | 10 | 19 | 14 |
| FOT, sec | bums | 320 | 135 | 400 | 215 | 315 |
| HDT, °C, 264 psi | 88 | 74 | 68 | 79 | 71 | 73 |

As seen by the above data, phosphoramides as described herein are effective in reducing the flame out time of HIPS, optionally in the presence of PPE and/or rubber. It was unexpected that the flame out times would be so dramatically improved, i.e. decreased, with the addition of the phosphoramide to render the material V-2 under UL-94 classification. It was also unexpected that the HDT would be so high for the compositions containing the phosphoramide.

### EXAMPLE 6

Blends of 90 parts of a commercially available bisphenol A polycarbonate were prepared containing 10 parts of either RDP or XPP. The blends also contained conventional additives, including a UV screener and an antioxidant, which were not considered in determining proportions. The compositions were extruded and molded into transparent specimens. Optical properties (according to ASTM 1003-61), including % transmission, yellowness index, and haze, and the Tg of the polycarbonate phase were determined for test specimens of each blend. The results are given in Table IV along with results for a comparable composition containing essentially 100% of the same polycarbonate and no added flame retardant.

**TABLE IV**

| Sample | Base | 14* | 15 |
|---|---|---|---|
| Polycarbonate | 100 | 90 | 90 |
| RDP | 0 | 10 | 0 |
| XPP | 0 | 0 | 10 |
| Tg, °C | 149 | 111 | 131 |
| Transmission, % | 90.1 | 88.3 | 89.5 |
| Haze | 0.7 | 3.3 | 0.7 |
| Yellowness index | 2.24 | 3.18 | 4.16 |

| | | | |
|---|---|---|---|
| * comparative | | | |

The above data show that the composition containing XPP has the same % transmission and haze as a specimen of essentially pure polycarbonate, and an acceptable yellowness index. Compared to the base sample, the decrease in polycarbonate Tg is only 18°C for the specimen containing XPP compared to 38°C for the specimen containing RDP.

### EXAMPLE 7

A blend of 26.5 parts of a first bisphenol A homopolycarbonate, 61.8 parts of a second bisphenol A homopolycarbonate with weight average molecular weight about 71% of that of the first bisphenol A homopolycarbonate, 4 parts of a commercially available bulk ABS copolymer, and 5 parts XPP was prepared by blending in a Henschel mixer followed by extrusion on a twin screw extruder and molded into test specimens. The blend also contained 2.75 parts conventional additives including titanium dioxide and polytetrafluoroethylene dispersed within styrene-acrylonitrile copolymer as an anti-drip agent. Measurement of the Melt Volume Rate (260°C and 5 kilograms applied weight) for the blend gave a value of 24.9 cubic centimeters per 10 minutes. The blend showed a melt viscosity at 280°C of 390 Pascal-seconds (Pa-s) at a shear rate of 100 sec⁻¹, 220 Pa-s at a shear rate of 1500 sec⁻¹, and 72 Pa-s at a shear rate of 10000 sec⁻¹. The observed FOT (total flameout times for first and second ignitions for 5 bars of 1.52 mm (0.06 inch) thickness) was 21.5 seconds. A Ball Pressure Test run on test specimens at 125°C according to test protocol IEC 695-10-2 (1995-08) gave puncture diameter of 1.6 millimeters (mm). Typically, a value of less than 2 mm is desirable for most applications.

### EXAMPLE 8

A blend of 64.3 parts bisphenol A homopolycarbonate, 16 parts of a copolycarbonate comprising 45 mole % bisphenol A and 55 mole % 4,4'-(3,3,5-trimethylcyclohexylidene)diphenol (APEC 9371 obtained from Bayer Corp. ); 4 parts of a commercially available high rubber graft ABS copolymer; 6 parts of a commercially available SAN copolymer, and 9 parts XPP was prepared by blending in a Henschel mixer followed by extrusion on a twin screw extruder and molded into test specimens. The blend also contained 0.7 parts of conventional additives including polytetrafluoroethylene dispersed within styrene-acrylonitrile copolymer as an anti-drip agent. The blend showed a glass transition temperature of 139°C. The observed FOT (total flameout times for first and second ignitions for 5 bars of 1.52 mm (0.06 inch) thickness) was 24 seconds. EXAMPLE 9

The same composition of Example 8 was prepared except that 16 parts of a copolycarbonate comprising 65 mole % bisphenol A and 35 mole % 4,4'-(3,3,5-trimethylcyclo-hexylidene)diphenol (APEC 9351 obtained from Bayer Corp.) was used. The blend showed a glass transition temperature of 140°C. The observed FOT (total flameout times for first and second ignitions for 5 bars of 1.52 mm (0.06 inch) thickness) was 21 seconds.

### EXAMPLE 10

This example demonstrates a preferred method for preparing a phosphoramide of the present invention substantially free of acidic, basic, or halide impurities, or their precursors. A mixture of 2,6-xylenol (69.3 kg), magnesium chloride (2.075 kg), and phosphoryl chloride (44 kg) was mixed and gradually warmed in stages to 146°C with stirring as hydrogen chloride was evolved. When an aliquot showed that the reaction was about 92% complete by nuclear magnetic resonance spectroscopy.(NMR), an additional 1.1 kg of phosphoryl chloride was added. When an aliquot showed that the reaction was about 94% complete by NMR, an additional 2 kg of phosphoryl chloride was added. When an aliquot showed that the reaction was about 98% complete by NMR, an additional 1.1 kg of phosphoryl chloride was added, after which the temperature was lowered to about 120°C. The reaction mixture was sparged with nitrogen for several hours and then cooled to about 59°C. Methylenechloride (150 kg) was added and the reaction mixture was filtered to remove solids. The filtrate was treated with piperazine (11.6 kg), triethylamine (33.8 kg), and additional methylenechloride (34.5 kg), after which the stirred reaction mixture was refluxed for about 10 hours. Additional methylenechloride (140 kg) was added and the reaction mixture was extracted twice with 1M hydrochloric acid, three times with water, and distilled to remove a portion of the methylenechloride and some residual water. The reaction mixture was treated with methanol at about 45°C, and then cooled, and filtered to isolate crystalline product. Analysis typically showed 90-92% yield of phosphoramide (XPP) containing less than 0.1 wt% X-PYRO.

### COMPARATIVE EXAMPLE 11

This example demonstrates a method for preparing a phosphoramide which is not substantially free of acidic, basic, or halide impurities, or their precursors. To a suspension of sodium carbonate (6.2 g), triethyl amine (0.074 g), piperazine (2.5 g), and methylenechloride (60 ml) was added dixylyl chlorophosphate (20.1 g) in 40 ml methylene chloride over 45 minutes with vigorous stirring. The mixture was stirred vigorously for 2 hours, then heated to reflux for 23 hours. A high performance liquid chromatography (HPLC) sample shows a 37:33 area ratio of XPP to X-PYRO.

### COMPARATIVE EXAMPLE 12

This example demonstrates a method for preparing a phosphoramide which is not substantially free of acidic, basic, or halide impurities, or their precursors. A solution of triethylamine (6.3 g) and piperazine (2.54 g) in chloroform (70 mL) was added to a solution of dixylyl chlorophosphate (20.0 g) in chloroform (70 mL) with stirring over a 90 minute period. The reaction was heated at reflux for 24 hours. HPLC analysis shows a 4:1 ratio of XPP to X-PYRO.

### EXAMPLE 13

This example demonstrates a method for preparing X-PYRO. A 1500 mL, 3 neck, round bottom flask was equipped with a pressure equalizing addition funnel, overhead stirrer, and condenser. The flask was charged under nitrogen with 0.509 moles water, 1.01 moles triethyl amine, and 700 ml toluene. To the mixture was added a solution of 1.060 moles dixylyl chlorophosphate in 700 mL toluene drop-wise over 3 hours. The reaction mixture was stirred at room temperature for 24 hours, then washed with water. The organic layer was collected and evaporated. The solid product obtained was recrystallized twice using methanol and chloroform. The yield of X-PYRO was 80% (melting point 150°C), and the purity was confirmed by HPLC and NMR.

### EXAMPLE 14

Blends of 88 parts of a bisphenol A polycarbonate, 7 parts of a commercially available high rubber graft ABS copolymer and 5 parts of a commercially available SAN copolymer were prepared under identical conditions as for Example 1. The blends also contained conventional additives including 0.5 part of polytetrafluoroethylene dispersed within styrene-acrylonitrile copolymer as an anti-drip agent, which were not considered in determining proportions. The blends also contained various amounts of XPP mixed with X-PYRO. The blend formulations are given in Table V.

**TABLE V**

| Sample | 1 | 2 | 3 | 4 | 5 | 6 |
|---|---|---|---|---|---|---|
| | | | | | | |
| XPP | 9.3 | 9.1 | 8.9 | 8.75 | 8.55 | 8:4 |
| X4Pyro | 0 | 0.2 | 0.4 | 0.55 | 0.75 | 0.9 |
| % X-Pyro in XPP | 0% | 2% | 4% | 6% | 8% | 10% |

Figure 1 shows the normalized molecular weights for polycarbonate portions obtained from molded test parts of each blend exposed to 100% relative humidity and 100°C for 24 hours. The data show that compositions with increasing levels of the X-PYRO impurity show accelerated molecular weight degradation for polycarbonate.

## Claims

1. A resin composition comprising the following and any reaction products thereof:
a) a thermoplastic resin, and
b) at least one phosphoramide having a glass transition point of at least 0°C and having the formula VI: 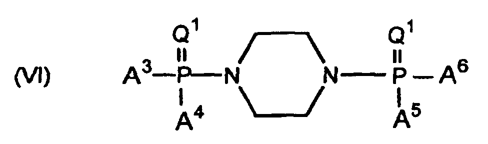
wherein each Q¹ is independently oxygen or sulfur and each A moiety is a 2,6-dimethylphenoxy moiety or a 2,4,6-trimethylphenoxy moiety.

2. The composition of claim 1 wherein the thermoplastic resin is selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin.

3. The composition of claim 1 wherein the thermoplastic resin is selected from the group consisting of high impact polystyrene resin, syndiotactic polystyrene, polyphenylene ether / high impact polystyrene resin blends, polyphenylene ether / syndiotactic polystyrene resin blends, polycarbonate SAN blends, polycarbonate-ABS blends, polycarbonate-SAN-ABS blends, and polycarbonate-polyester blends.

4. The composition of claim 1 wherein the thermoplastic resin is at least one of polyesters, polycarbonates, polyphenylene ethers, high impact polystyrenes, syndiotactic polystyrenes, acrylonitrile-butadiene-styrene copolymers, and styrene-acrylonitrile copolymers.

5. The composition of claim 1 wherein the thermoplastic resin comprises at least one polycarbonate and ABS.

6. The composition of claim 5 wherein the at least one polycarbonate comprises bisphenol A polycarbonate and a copolycarbonate of bisphenol A and 4,4'-(3,3,5-trimethylcyclo-hexylidene)diphenol.

7. The composition of claim 1 wherein the phosphoramide is of the formula VI and each Q¹ is oxygen; and each A moiety is a 2,6-dimethylphenoxy moiety.

8. The composition of claim 1 wherein the thermoplastic resin comprises polyphenylene ether and high impact polystyrene resin.

9. The composition of any preceding claim further comprising at least one non-polymeric or polymeric phosphorus additive selected from the group consisting of organic phosphate esters, thiophosphate esters, phosphonate esters, thiophosphonate esters, phosphinate esters, thiophosphinate esters, phosphine oxides, and thiophosphine oxides.

10. The composition of claim 1 wherein the total amount of phosphorus per 100 parts of resinous materials is in the range of about 0.1-3 parts by weight.

11. The composition of claim 1 which is essentially free of chlorine and bromine.

12. An article made from the composition of any preceding claim.

13. The article of claim 12 which is a deflection yoke for cathode ray tube, deflection yoke for television, slit type deflection yoke, mold coil deflection yoke, television backplate, docking station, pedestal, bezel, pallet, switch, switch housing, plug, plug housing, electrical connector, connecting device, socket, television housing, computer housing, desk-top computer housing, portable computer housing, lap-top computer housing, palm-held computer housing; monitor housing, printer housing, keyboard, FAX machine housing, copier housing, telephone housing, mobile phone housing, radio sender housing, radio receiver housing, light fixture, battery charger housing, battery housing, automotive electrical component, antenna housing, transformer housing, modem, cartridge, network interface device housing, circuit breaker housing, meter housing, panel for wet or dry appliance, dishwasher panel, clothes washer panel, clothes dryer panel, refrigerator panel; heating or ventilation enclosure, fan, air conditioner housing, cladding or seating for public transportation; or cladding or seating for trains, subways, or buses.

14. A method to increase the heat distortion temperature of a flame resistant composition containing an amount of a phosphorus-containing compound effective to render the composition a flame rating of at least V-2 in the Underwriter's Laboratory UL-94 protocol when measured on a test specimen of 3.18 mm (0.125 inch) by 12.7 mm (5 inch) by 12.7 cm (5 inch) dimensions, wherein the method comprises combining at least one thermoplastic resin and at least one phosphoramide having a glass transition point of at least about 0°C, and being substantially free of acidic, basic or halide impurities, or their precursors, said phosphoramide having the formula VI: 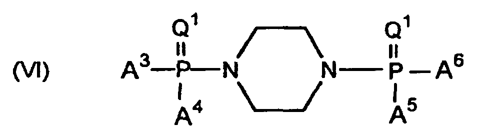 wherein each Q¹ is independently oxygen or sulfur and each A moiety is a 2,6-dimethylphenoxy moiety or a 2,4,6-trimethylphenoxy moiety.

15. The method of claim 14 wherein the thermoplastic resin is selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin.

16. The method of claim 14 wherein the thermoplastic resin is a polycarbonate resin or a blend containing at least one polycarbonate resin.

17. The method of claim 14 wherein the thermoplastic resin comprises at least one polycarbonate and ABS.

18. The method of claim 17 wherein the at least one polycarbonate comprises bisphenol A polycarbonate and a copolycarbonate of bisphenol A and 4,4'-(3,3,5-trimethylcyclo-hexylidene)diphenol.

19. The method of claim 14 wherein the method further comprises at least one non-polymeric or polymeric phosphorus additive selected from the group consisting of organic phosphate esters, thiophosphate esters, phosphonate esters, thiophosphonate esters, phosphinate esters, thiophosphinate esters, phosphine oxides, and thiophosphine oxides.

20. The method of claim 14 in which the composition is essentially free of chlorine and bromine.

## Patentansprüche

1. Eine Harzzusammensetzung umfassend das Folgende sowie jegliche Reaktionsprodukte daraus:
a) ein thermoplastisches Harz, und
b) wenigstens ein Phosphoramid mit einem Glasübergangspunkt von wenigstens 0°C und mit der Formel VI: 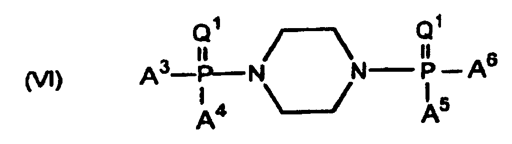
worin jedes Q¹ unabhängig Sauerstoff oder Schwefel ist und jeder Rest A ein 2,6-Dimethylphenoxyrest oder ein 2,4,6-Trimethylphenoxyrest ist.

2. Zusammensetzung nach Anspruch 1, **dadurch gekennzeichnet, dass** das thermoplastische Harz ausgewählt ist aus der Gruppe bestehend aus (i) Polycarbonatharzen und Blends enthaltend wenigstens ein Polycarbonatharz, (ii) Polyphenylenetherharzen und Blends enthaltend wenigstens ein Polyphenylenetherharz, (iii) Polystyrolharz und Blends enthaltend Polystyrolharz, (iv) Styrol enthaltenden Copolymerharzen und Blends enthaltend styrolhaltige Copolymerharze; (v) Styrol enthaltendes Pfropfcopolymerharz und Blends enthaltend Styrol enthaltendes Propfcopolymerharz; und (vi) hochschlagzähes Polystyrolharz und Blends enthaltend hochschlagzähes Polystyrolharz.

3. Zusammensetzung nach Anspruch 1, **dadurch gekennzeichnet, dass** das thermoplastische Harz ausgewählt ist aus der Gruppe bestehend aus hochschlagfestem Polystyrolharz, syndiotaktischem Polystyrol, Polyphenylenether / hochschlagfestes Polystyrolharz Blends, Polyphenylenether / syndiotaktisches Polystyrolharz Blends, Polycarbonat SAN Blends, Polycarbonat-ABS Blends, Polycarbonat-SAN-ABS Blends, und Polycarbonat-Polyester Blends.

4. Zusammensetzung nach Anspruch 1, **dadurch gekennzeichnet, dass** das thermoplastische Harz ein oder mehrere Polyester, Polycarbonate, Polyphenylenether, hochschlagfeste Polystyrole, syndiotaktische Polystyrole, Acrylnitril-Butadien-Styrol Copolymere und/oder Styrol-Acrylnitril Copolymere ist.

5. Zusammensetzung nach Anspruch 1, **dadurch gekennzeichnet, dass** das thermoplastische Harz wenigstens ein Polycarbonat und ABS umfasst.

6. Zusammensetzung nach Anspruch 5, **dadurch gekennzeichnet, dass** das wenigstens eine Polycarbonat Bisphenol A Polycarbonat und ein Copolycarbonat aus Bisphenol A und 4,4'-(3,3,5-Trimethylcyclo-hexyliden)diphenol umfasst.

7. Zusammensetzung nach Anspruch 1, **dadurch gekennzeichnet, dass** das Phosphoramid die Formel VI besitzt und jedes Q¹ Sauerstoff ist; und jeder A Rest ist ein 2,6- Dimethylphenoxyrest ist.

8. Zusammensetzung nach Anspruch 1, **dadurch gekennzeichnet, dass** das thermoplastische Harz Polyphenylenether und hochschlagfestes Polystyrolharz umfasst.

9. Zusammensetzung nach einem der vorherergehenden Ansprüche weiterhin aufweisend wenigstens ein nicht-polymeres oder polymeres Phosphoradditiv ausgewählt aus der Gruppe bestehend aus organischen Phosphatestern, Thiophosphatestern, Phosphonatestern, Thiophosphonatestern, Phosphinatestern, Thiophosphinatestem, Phosphinoxiden und Thiophosphinoxiden.

10. Zusammensetzung nach Anspruch 1, **dadurch gekennzeichnet, dass** die Gesamtmenge an Phosphor pro 100 Teile des harzartigen Materials im Bereich von etwa 0,1 bis 3 Gewichtsteilen liegt.

11. Zusammensetzung nach Anspruch 1, **dadurch gekennzeichnet, dass** sie im Wesentlichen frei von Chlor und Brom ist.

12. Ein Gegenstand hergestellt aus der Zusammensetzung nach einem vorhergehenden Anspruch.

13. Gegenstand nach Anspruch 12, **dadurch gekennzeichnet, dass** es sich um ein Ablenkspulenjoch für eine Kathodenstrahlröhre, ein Ablenkspulenjoch für ein Fernsehgerät, ein schlitzartiges Ablenkspulenjoch, einen Formspulenablenkjoch, eine Fernsehgerätrückenabdeckung, eine Dockingstation, einen Bedienpult, eine Blende, eine Palette, einen Schalter, ein Schaltergehäuse, einen Stecker, ein Steckergehäuse, einen elektrischen Verbinder, eine Verbindungsanordnung, eine Anschlussdose, ein Femsehgerätgehäuse, ein Computergehäuse, ein Desktopcomputergehäuse, ein Gehäuse für einen tragbaren Computer, Laptopcomputergehäuse, ein Computergehäuse für einen Palm; ein Monitorgehäuse, ein Druckergehäuse, Keyboard, ein Gehäuse für ein Faxgerät, ein Kopierergehäuse, ein Telefongehäuse, ein Handygehäuse, Gehäuse für einen Radiosender, Gehäuse für einen Radioempfänger, eine Leuchte, ein Gehäuse für ein Batterieladegerät, ein Batteriegehäuse, eine elektrische Komponente für ein Automobil, ein Antennengehäuse, ein Transformatorengehäuse, ein Modem, eine Kassette, ein Gehäuse für ein Netzwerkinterface, ein Gehäuse für einen Hauptschalter, ein Instrumentengehäuse, eine Bedienplatte für eine Nass- oder Trockeneinrichtung, eine Bedienplatte für einen Geschirrspüler, eine Bedienplatte für eine Waschmaschine, eine Bedienplatte für einen Kleidertrockner, eine Bedienplatte für einen Kühlschrank; eine Heizungs- oder Ventilationsabdeckung, ein Gebläse, ein Gehäuse für eine Klimaanlage, Verkleidung oder Sitze für den öffentlichen Transport; oder Verkleidung oder Sitze für Züge, U-Bahnen oder Busse handelt.

14. Verfahren zur Verbesserung der Wärmeverformungstemperatur einer flammhemmenden Zusammensetzung enthaltend eine Menge einer Phosphor enthaltenden Verbindung, welche der Zusammensetzung wirksam eine Flammbeurteilung von wenigstens V-2 nach dem Underwriter's Laboratory UL-94 Protokoll verleiht, gemessen an einem Testkörper der Dimension 3,18 mm (0,125 inch) mal 12,7 mm (0,5 inch) mal 12,7 cm (5 inch), wobei das Verfahren aufweist, dass man wenigstens ein thermoplastisches Harz und wenigstens ein Phosphoramid kombiniert, das einen Glasübergangspunkt von wenigstens etwa 0°C hat, und im Wesentlichen frei von sauren, basischen oder Halogen-Verunreinigungen ist, oder deren Vorläufer, wobei das Phosphoramid die Formel VI hat: 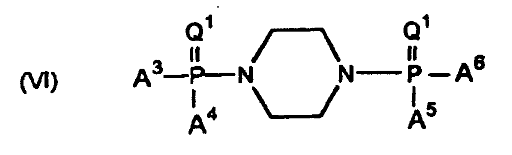 worin jedes Q¹ unabhängig Sauerstoff oder Schwefel ist und jeder Rest A ein 2,6-Dimethylphenoxyrest oder ein 2,4,6-Trimethylphenoxyrest ist.

15. Verfahren nach Anspruch 14, **dadurch gekennzeichnet, dass** das thermoplastische Harz ausgewählt ist aus der Gruppe bestehend aus (i) Polycarbonatharzen und Blends enthaltend wenigstens ein Polycarbonatharz, (ii) Polyphenylenetherharzen und Blends enthaltend wenigstens ein Polyphenylenetherharz, (iii) Polystyrolharz und Blends enthaltend Polystyrolharz, (iv) Styrol enthaltenden Copolymerharzen und Blends enthaltend styrolhaltige Copolymerharze; (v) Styrol enthaltendes Pfropfcopolymerharz und Blends enthaltend styrolenthaltendes Propfcopolymerharz; und (vi) hochschlagzähes Polystyrolharz und Blends enthaltend hochschlagzähes Polystyrolharz.

16. Verfahren nach Anspruch 14, **dadurch gekennzeichnet, dass** das thermoplastische Harz ein Polycarbonatharz oder ein Blend enthaltend wenigstens ein Polycarbonatharz ist.

17. Verfahren nach Anspruch 14, **dadurch gekennzeichnet, dass** das thermoplastische Harz wenigstens ein Polycarbonat und ABS umfasst.

18. Verfahren nach Anspruch 17, **dadurch gekennzeichnet, dass** das wenigstens eine Polycarbonat Bisphenol A Polycarbonat und ein Copolycarbonat aus Bisphenol A und 4,4'-(3,3,5-Trimethylcyclo-hexyliden)diphenol aufweist.

19. Verfahren nach Anspruch 14, **dadurch gekennzeichnet, dass** das Verfahren weiterhin aufweist wenigstens ein nicht-polymeres oder polymeres Phosphoradditiv ausgewählt aus der Gruppe bestehend aus organischen Phosphatestern, Thiophosphatestern, Phosphonatestem, Thiophosphonatestern, Phosphinatestem, Thiophosphinatestem, Phosphinoxiden und Thiophosphinoxiden.

20. Verfahren nach Anspruch 14, **dadurch gekennzeichnet, dass** die Zusammensetzung im Wesentlichen frei von Chlor und Brom ist.

## Revendications

1. Composition à base de résine, qui comprend les constituants suivants et tout produit de réaction de ces constituants :
a) une résine thermoplastique, et
b) au moins un phosphoramide ayant un point de transition vitreuse d'au moins 0°C et répondant à la formule VI : 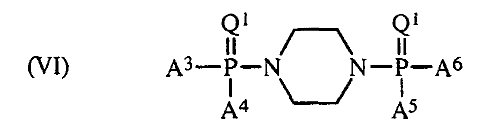
dans laquelle chaque Q¹ représente indépendamment un atome d'oxygène ou de soufre et chaque fragment A représente un groupe 2,6-diméthylphénoxy ou 2,4,6-triméthylphénoxy.

2. Composition selon la revendication 1, dont la résine thermoplastique est une résine choisie parmi (i) les résines de polycarbonate et les mélanges contenant au moins une résine de polycarbonate, (ii) les résines de poly(oxyde de phénylène) et les mélanges contenant au moins une résine de poly(oxyde de phénylène), (iii) les résines de polystyrène et les mélanges contenant une résine de polystyrène, (iv) les résines de copolymère contenant du styrène et les mélanges contenant une telle résine, (v) les résines de copolymère greffé contenant du styrène et les mélanges contenant une telle résine, et (vi) les résines de polystyrène à haute résistance au choc et les mélanges contenant une telle résine.

3. Composition selon la revendication 1, dont la résine thermoplastique est une résine choisie parmi la résine de polystyrène à haute résistance au choc, la résine de polystyrène syndiotactique, les mélanges poly(oxyde de phénylène)/résine de polystyrène à haute résistance au choc, les mélanges poly(oxyde de phénylène)/résine de polystyrène syndiotactique, les mélanges polycarbonate-SAN, les mélanges polycarbonate-ABS, les mélanges polycarbonate-SAN-ABS, et les mélanges polycarbonate-polyester.

4. Composition selon la revendication 1, dont la résine thermoplastique est au moins une résine prise parmi les polyesters, les polycarbonates, les poly(oxyde de phénylène), les polystyrènes à haute résistance au choc, les polystyrènes syndiotactiques, les copolymères acrylonitrile-butadiène-styrène, et les copolymères styrène-acrylonitrile.

5. Composition selon la revendication 1, dont la résine thermoplastique comprend au moins un polycarbonate et un ABS.

6. Composition selon la revendication 5, pour laquelle le au moins un polycarbonate comprend un polycarbonate issu du bisphénol A et un copolycarbonate issu du bisphénol A et du 4,4'-(3,3,5-triméthylcyclohexylidène)diphénol.

7. Composition selon la revendication 1, dont le phosphoramide de formule VI est un phosphoramide pour lequel chaque Q¹ représente un atome d'oxygène, et chaque fragment A représente un groupe 2,6-diméthylphénoxy.

8. Composition selon la revendication 1, dont la résine thermoplastique comprend une résine de poly(oxyde de phénylène) et une résine de polystyrène à haute résistance au choc.

9. Composition selon l'une quelconque des revendications précédentes, qui renferme en outre au moins un additif phosphoré, polymère ou non-polymère, pris parmi les esters phosphate organiques, les esters thiophosphate, les esters phosphonate, les esters thiophosphonate, les esters phosphinate, les esters thiophosphinate, les oxydes de phosphine et les thiophosphines.

10. Composition selon la revendication 1, pour laquelle la quantité totale de phosphore est d'environ 0,1 à environ 3 parties en poi ds pour 100 parties de matières résineuses.

11. Composition selon la revendication 1, qui est pratiquement exempte de chlore et de brome.

12. Article fabriqué à partir d'une composition selon l'une quelconque des revendications précédentes.

13. Article selon la revendication 12, qui est un collier de déflexion pour tube à rayons cathodiques, un collier de déflexion pour la télévision, un collier de déflexion du type à fente, un collier de déflexion à bobine moulée, une plaque arrière de télévision, un poste d'accostage, un socle, un biseau, une palette, un commutateur, un logement de commutateur, une fiche, un logement de fiche, un connecteur électrique, un dispositif de connexion, un plot, un logement de télévision, un logement d'ordinateur, un logement d'ordinateur de bureau, un logement d'ordinateur portable, un logement d'ordinateur portatif, un logement d'ordinateur tenu dans la paume, un logement d'écran de contrôle, un logement d'imprimante, un clavier, un logement de machine FAX, un logement de copieur, un logement de téléphone, un logement de téléphone mobile, un logement d'émetteur radio, un logement de récepteur radio, un appareil fixe lumineux, un logement de chargeur de batterie, un logement de batterie, un composant électrique d'automobile, un logement d'antenne, un logement de transformateur, un modem, une cartouche, un logement de dispositif d'interface de réseau, un logement de coupe-circuit, un logement d'appareil de mesure, un panneau pour appareil de traitement à sec ou par voie humide, un panneau de lave-vaisselle, un panneau de machine à laver les vêtements, un panneau de machine à sécher les vêtements, un panneau de réfrigérateur, une enceinte de chauffage ou de ventilation, un ventilateur, un logement de climatiseur, un revêtement ou un siège pour le transport du public, ou un revêtement ou un siège pour les trains, les métros ou les autobus.

14. Procédé pour augmenter la température de déformation à chaud d'une composition résistant à l'inflammation, contenant une proportion d'un composé phosphoré permettant d'attribuer à la composition un classement quant à l'inflammabilité d'au moins V-2 dans le protocole UL-94 de Underwriter's Laboratory lorsque les mesures sont effectuées sur un échantillon de dimensions 3,18 mm (0,125 pouces) x 12,7 mm (0,5 pouce) x 12,7 cm (5 pouces), procédé qui comprend la combinaison d'au moins une résine thermoplastique et d'au moins un phosphoramide ayant un point de transition vitreuse d'au moins environ 0°C et pratiquement exempt d'impuretés acides, basiques ou halogénées ou de leurs précurseurs, ledit phosphoramide répondant à la formule VI : 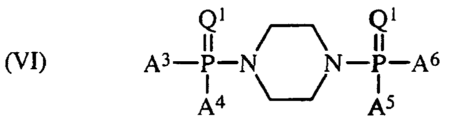 dans laquelle chaque Q¹ représente indépendamment un atome d'oxygène ou de soufre et chaque fragment A représente un groupe 2,6-diméthylphénoxy ou 2,4,6-triméthylphénoxy.

15. Procédé selon la revendication 14, dans lequel la résine thermoplastique est une résine choisie parmi (i) les résines de polycarbonate et les mélanges contenant au moins une résine de polycarbonate, (ii) les résines de poly(oxyde de phénylène) et les mélanges contenant au moins une résine de poly(oxyde de phénylène), (iii) les résines de polystyrène et les mélanges contenant une résine de polystyrène, (iv) les résines de copolymère contenant du styrène et les mélanges contenant une telle résine, (v) les résines de copolymère greffé contenant du styrène et les mélanges contenant une telle résine, et (vi) les résines de polystyrène à haute résistance au choc et les mélanges contenant une telle résine.

16. Procédé selon la revendication 14, dans lequel la résine thermoplastique est une résine de polycarbonate ou un mélange contenant au moins une résine de polycarbonate.

17. Procédé selon la revendication 14, dans lequel la résine thermoplastique comprend au moins un polycarbonate et un ABS.

18. Procédé selon la revendication 17, dans lequel le au moins un polycarbonate comprend un polycarbonate issu du bisphénol A et un copolycarbonate issu du bisphénol A et du 4,4'-(3,3,5-triméthylcyclohexylidène)diphénol.

19. Procédé selon la revendication 14, dans lequel la composition renferme en outre au moins un additif phosphoré, polymère ou non-pol ymère, pris parmi les esters phosphate organiques, les esters thiophosphate, les esters phosphonate, les esters thiophosphonate, les esters phosphinate, les esters thiophosphinate, les oxydes de phosphine et les thiophosphines.

20. Procédé selon la revendication 14, dans lequel la composition est pratiquement exempte de chlore et de brome.
